# EUROPEAN PATENT SPECIFICATION

(11) **EP 4 210 193 B1**
(45) Date of publication and mention of the grant of the patent: **23.09.2026**
(21) Application number: 21900938.8
(22) Date of filing: 26.11.2021
(51) Int. Cl.: H02J 7/00, G01R 31/382, G01R 19/165, H01M 10/44

(54) **METHOD FOR CHARGING PLURALITY OF BATTERIES, AND ELECTRONIC DEVICE TO WHICH METHOD IS APPLIED**
VERFAHREN ZUM LADEN EINER VIELZAHL VON BATTERIEN UND ELEKTRONISCHE VORRICHTUNG MIT DARAUF ANGEWANDTEM VERFAHREN
PROCÉDÉ DE CHARGE D'UNE PLURALITÉ DE BATTERIES ET DISPOSITIF ÉLECTRONIQUE AUQUEL LE PROCÉDÉ EST APPLIQUÉ

(30) Priority: 04.12.2020 KR 20200168607
(43) Date of publication of application: 12.07.2023
(73) Proprietor: Samsung Electronics Co., Ltd., Suwon-si, Gyeonggi-do 16677 (KR)
(72) Inventor: CHOI, Hangseok, Suwon-si, Gyeonggi-do 16677 (KR)
(74) Representative: Gulde & Partner
(86) International application number: PCT/KR2021/017662
(87) International publication number: WO 2022/119250

(56) References cited:
- JP-A- 2007 205 878
- JP-A- 2007 205 878
- JP-A- 2015 061 404
- JP-A- 2015 061 404
- KR-B1- 102 120 797
- US-A1- 2005 275 374
- US-A1- 2014 159 666
- US-B2- 7 394 225
- US-B2- 8 098 053

## Description

### [TECHNICAL FIELD]

The disclosure relates to a method of charging a plurality of batteries and an electronic device applying the method.

### [BACKGROUND ART]

Electronic devices may receive power stored in a battery and may operate for a predetermined time while being separated from an external power source. The battery may be discharged while supplying power to the electronic device. When the electronic device is connected to the external power source, a discharged battery may be charged. The US 2014/0159666 A1 discloses a charge control device that controls a charging current to be supplied to a plurality of chargeable and dischargeable cell modules, wherein the charging current is controlled based on the maximum current value in each of the plurality of cell modules. The JP 2007 205878 A discloses a secondary battery capacitor estimation system including a constant current charging with successive constant voltage charging. The US 2005/275374 A1 discloses multiple cell battery chargers according to the prior arts and JP 2015 061404 A discloses a secondary battery system having a protective function of interrupting current when an abnormality occurs.

The above information is presented as background information only to assist with an understanding of the disclosure. No determination has been made, and no assertion is made, as to whether any of the above might be applicable as prior art with regard to the disclosure.

### [DISCLOSURE]

### [Technical Problem]

The electronic device may include two or more batteries charged with one charger according to design, in this case, the two or more batteries may have different capacities or may have different impedances in the charging paths of each battery depending on a connection path with the charger. Accordingly, an asymmetry of the charging current of each battery may occur, and a battery with a relatively large charging current may have a problem of shortening the battery lifetime due to overcurrent and overvoltage, and a battery having a relatively high impedance in the charging path may delay the time it takes to reach a full charge.

Aspects of the disclosure are to address at least the above-mentioned problems and/or disadvantages and to provide at least the advantages described below. Accordingly, an aspect of the disclosure is to provide an electronic device that prevents an overcurrent or overvoltage situation of a battery and shortens a time required for all batteries to be fully charged, and an operating method thereof, in an electronic device including two or more batteries charged with one charger but having different charging paths.

Additional aspects will be set forth in part in the description which follows and, in part, will be apparent from the description, or may be learned by practice of the presented embodiments.

### [Technical Solution]

In accordance with the invention, an electronic device is provided according to claim 1 of the appended claims.

In accordance with another aspect of the invention, a method of charging a battery of an electronic device includes the features of claim 9.

### [Advantageous Effects]

Various embodiments disclosed in the disclosure may provide an electronic device that prevents an overcurrent or overvoltage situation of a battery and shortens a time required for all batteries to be fully charged, and an operating method thereof, in an electronic device including two or more batteries charged with one charger but having different charging paths.

Other aspects, advantages, and salient features of the disclosure will become apparent to those skilled in the art from the following detailed description, which, taken in conjunction with the annexed drawings, discloses various embodiments of the disclosure.

### [DESCRIPTION OF DRAWINGS]

The above and other aspects, features, and advantages of certain embodiments of the disclosure will be more apparent from the following description taken in conjunction with the accompanying drawings, in which:
FIG. 1 is a block diagram illustrating an electronic device 101 in a network environment according to an embodiment of the disclosure;
FIG. 2 is a diagram schematically illustrating a circuit diagram for charging a battery of an electronic device according to an embodiment of the disclosure;
FIG. 3 is a flowchart illustrating an operation of an electronic device including a circuit diagram for charging a battery of FIG. 2 according to an embodiment of the disclosure;
FIG. 4 is graphs illustrating a battery charging process of an electronic device to which a flowchart of FIG. 3 is applied according to an embodiment of the disclosure;
FIG. 5 is graphs illustrating a battery charging process in a case of an electronic device to which a first operation section is not applied in a flowchart of FIG. 3 according to an embodiment of the disclosure;
FIG. 6 is a flowchart illustrating an operation of an electronic device including a circuit diagram for charging a battery of FIG. 2 according to an embodiment of the disclosure;
FIG. 7 is graphs illustrating a battery charging process in a case of an electronic device to which a first operation section is not applied in a flowchart of FIG. 6 according to an embodiment of the disclosure; and
FIG. 8 is graphs illustrating a battery charging process of an electronic device to which a flowchart of FIG. 6 is applied according to an embodiment of the disclosure.

The same reference numerals are used to represent the same elements throughout the drawings.

### [MODE FOR INVENTION]

The following description with reference to the accompanying drawings is provided to assist in a comprehensive understanding of various embodiments of the disclosure as defined by the claims and their equivalents. It includes various specific details to assist in that understanding but these are to be regarded as merely exemplary. Accordingly, those of ordinary skill in the art will recognize that various changes and modifications of the various embodiments described herein can be made without departing from the scope of the disclosure. In addition, descriptions of well-known functions and constructions may be omitted for clarity and conciseness.

The terms and words used in the following description and claims are not limited to the bibliographical meanings, but, are merely used by the inventor to enable a clear and consistent understanding of the disclosure. Accordingly, it should be apparent to those skilled in the art that the following description of various embodiments of the disclosure is provided for illustration purpose only and not for the purpose of limiting the disclosure as defined by the appended claims.

It is to be understood that the singular forms "a," "an," and "the" include plural referents unless the context clearly dictates otherwise. Thus, for example, reference to "a component surface" includes reference to one or more of such surfaces.

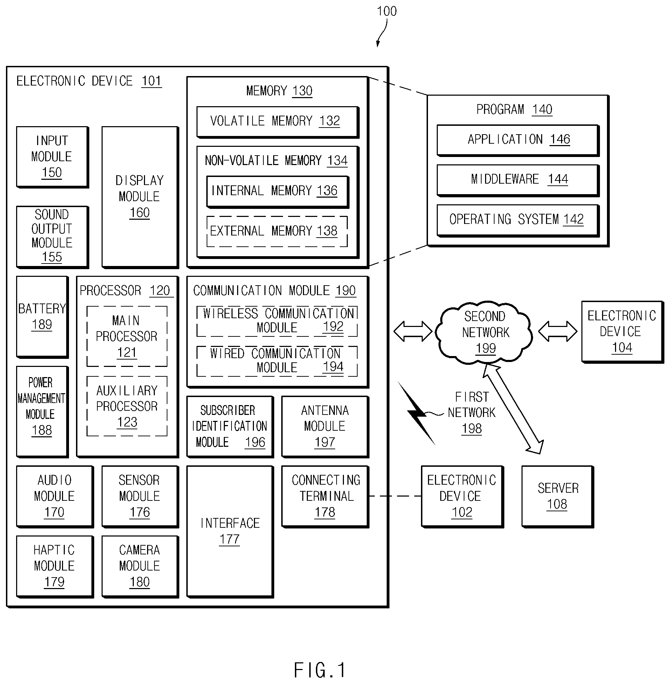

FIG. 1 is a block diagram illustrating an electronic device 101 in a network environment 100 according to an embodiment of the disclosure. Referring to FIG. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module (SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to one embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to one embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as Bluetooth^{™}, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adj acent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wiredly), wirelessly, or via a third element.

As used in connection with various embodiments of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStore^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

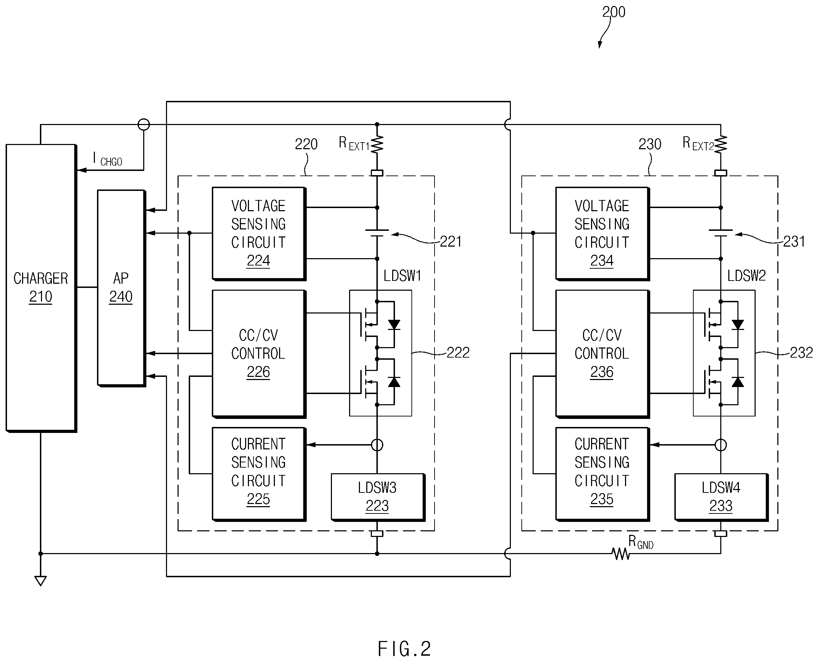

Hereinafter, an electronic device according to an embodiment will be described with reference to FIG. 2.

FIG. 2 is a diagram schematically illustrating a circuit diagram for charging a battery of an electronic device according to an embodiment of the disclosure.

Referring to FIG. 2, the electronic device (e.g., the electronic device 101 of FIG. 1) includes a charger 210, a first battery pack 220, a second battery pack 230, and a processor (AP) 240. The charger 210 is electrically connected to the first battery pack 220, the second battery pack 230, and the processor 240, and the processor 240 is also electrically connected to the first battery pack 220 and the second battery pack 230. The first battery pack 220 and the second battery pack 230 may be connected to the charger 210 in parallel.

According to an embodiment, the charger 210 may be electrically connected to an external power supply (e.g., Travel Adapter Charger), and may charge the first battery pack 220 and the second battery pack 230 through the charger 210. A charging path of the first battery pack 220 connected to the charger 210 may be different from a charging path of the second battery pack 230 connected to the charger 210. In the disclosure, it is assumed that the charging path of the second battery pack 230 has a greater impedance than the charging path of the first battery pack 220.

The first battery pack 220 may include a first battery cell 221, a first load switch (LDSW1) 222, a third load switch (LDSW3) 223, a first voltage sensing circuit 224, a first current sensing circuit 225, and a first constant current/constant voltage controller (CC/CV control) 226.

The first voltage sensing circuit 224 is electrically connected to both ends of the first battery cell 221 to sense a first battery cell voltage VB1, which is a voltage of the first battery cell 221, and may transmit the measured first battery cell voltage VB1 to the first constant current/constant voltage controller 226 electrically connected to the first voltage sensing circuit 224.

The first current sensing circuit 225 is electrically connected to a node between the first load switch (LDSW1) 222 and the third load switch (LDSW3) 223 to sense a first battery cell current IB1, which is a current of the first battery cell 221, and may transmit the measured first battery cell current IB1 to the first constant current/constant voltage controller 226 electrically connected to the first current sensing circuit 225.

The first constant current/constant voltage controller 226 may control the first load switch (LDSW1) 222 electrically connected to the first constant current/constant voltage controller 226 using a constant current output or a constant voltage output, based on the received first battery cell voltage VB1 and the received first battery cell current IB1.

The first load switch (LDSW1) 222 may perform constant voltage control and constant current control in response to a control of the first constant current/constant voltage controller 226. The first load switch (LDSW1) 222 may include at least one metal oxide silicon field effect transistor (MOSFET) switch, and the MOSFET switch of which a gate terminal may be connected to the first constant current/constant voltage controller 226. The first load switch (LDSW1) 222 may have one end connected to the first battery cell 221 and the other end connected to the third load switch (LDSW3) 223. The first load switch (LDSW1) 222 and the third load switch (LDSW3) 223 may protect the first battery pack 220 by preventing overvoltage and overcurrent of the first battery pack 220.

The second battery pack 230 may include a second battery cell 231, a second load switch (LDSW2) 232, a fourth load switch (LDSW4) 233, a second voltage sensing circuit 234, a second current sensing circuit 235, and a second constant current/constant voltage controller (CC/CV control) 236.

The second voltage sensing circuit 234 is electrically connected to both ends of the second battery cell 231 to sense the second battery cell voltage VB2, which is a voltage of the second battery cell 231, and may transmit the measured second battery cell voltage VB2 to the second constant current/constant voltage controller 236 electrically connected to the second voltage sensing circuit 234.

The second current sensing circuit 235 is electrically connected to a node between the second load switch (LDSW2) 232 and the fourth load switch (LDSW4) 233 to sense a second battery cell current IB2, which is a current of the second battery cell 231, and may transmit the measured second battery cell current IB2 to the second constant current/constant voltage controller 236 electrically connected to the second current sensing circuit 235.

The second constant current/constant voltage controller 236 may control the second load switch (LDSW2) 232 electrically connected to the second constant current/constant voltage controller 236 as a constant current output or a constant voltage output, based on the received second battery cell voltage VB2 and the received second battery cell current IB2.

The second load switch (LDSW2) 232 may perform constant voltage control and constant current control in response to a control of the second constant current/constant voltage controller 236. The second load switch (LDSW2) 232 may include at least one MOSFET switch, and the MOSFET switch of which a gate terminal may be connected to the second constant current/constant voltage controller 236. The second load switch (LDSW2) 232 may have one end connected to the second battery cell 231 and the other end connected to the fourth load switch (LDSW4) 233. The second load switch (LDSW2) 232 and the fourth load switch (LDSW4) 233 may protect the second battery pack 230 by preventing overvoltage and overcurrent of the second battery pack 230.

The processor 240 may receive the first battery cell voltage VB1 and the first battery cell current IB1 from the first constant current/constant voltage controller 226 of the first battery pack 220 or may receive the first battery cell voltage VB1 from the first voltage sensing circuit 224. In addition, the processor 240 may receive the second battery cell voltage VB2 and the second battery cell current IB2 from the second constant current/constant voltage controller 236 of the second battery pack 230 or may receive the second battery cell voltage VB2 from the second voltage sensing circuit 234. The processor 240 may control the charger 210 electrically connected to the processor 240 using the constant current output or and the constant voltage output, based on the received first battery cell voltage VB1, the received first battery cell current IB1, the received second battery cell voltage VB2, and the received second battery cell current IB2.

The charger 210 may control an output voltage VCHGO of the charger 210 to a constant voltage or may control an output current ICHGO of the charger 210 to a constant current, in response to the control of the processor 240 to charge the first battery pack 220 and/or the second battery pack 230.

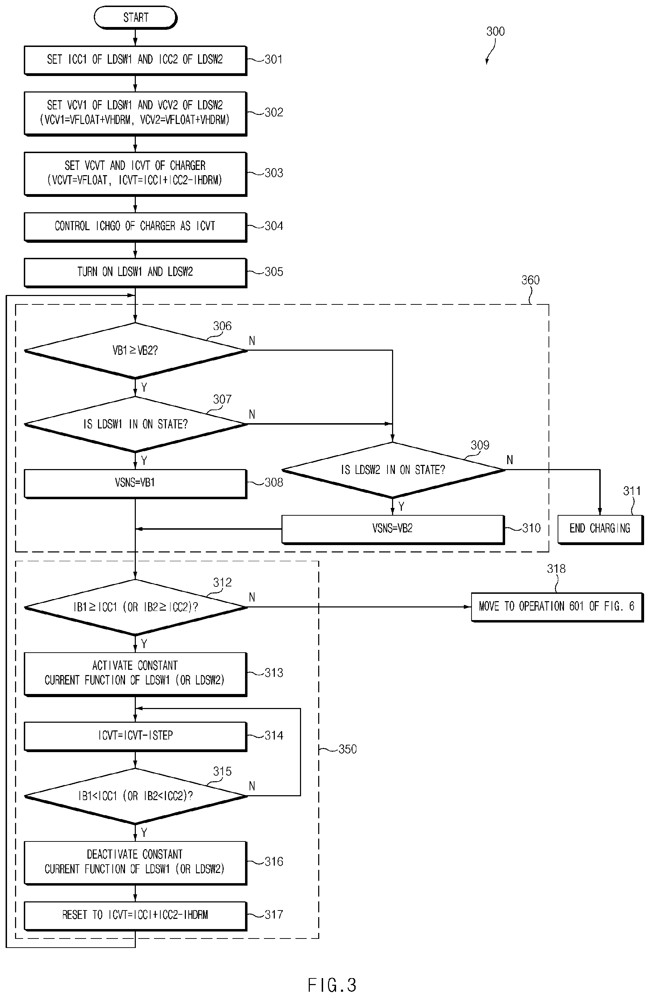

Hereinafter, an operation of an electronic device including the circuit diagram 200 for charging the battery of FIG. 2 will be described with reference to FIG. 3.

FIG. 3 is a flowchart 300 illustrating an operation of an electronic device including the circuit diagram 200 for charging a battery of FIG. 2 according to an embodiment of the disclosure.

Referring to FIGS. 2 and 3, in operation 301, the electronic device may set a first load switch target current value ICC1 for the constant current control of the first load switch (LDSW1) 222, and a second load switch target current value ICC2 for the constant current control of the second load switch (LDSW2) 232.

According to an embodiment, the first load switch target current value ICC1 of the first load switch (LDSW1) 222 may be the maximum charging current or the maximum allowable current of the first battery cell 221. The first load switch target current value ICC1 may be a target current value that is limited not to exceed the first battery cell current IB1 when the constant current function of the first load switch (LDSW1) 222 operates. The first load switch (LDSW1) 222, when the constant current function operates, may increase the impedance of the charging path of the first battery cell 221 such that the first battery cell current IB1 is maintained at the first load switch target current value ICC1.

According to an embodiment, the second load switch target current value ICC2 of the second load switch (LDSW2) 232 may be the maximum charging current or the maximum allowable current of the second battery cell 231. The second load switch target current value ICC2 may be a target current value that is limited not to exceed the second battery cell current IB2 when the constant current function of the second load switch (LDSW2) 232 operates. The second load switch (LDSW2) 232, when the constant current function operates, may increase the impedance of the charging path of the second battery cell 231 such that the second battery cell current IB2 is maintained at the second load switch target current value ICC2.

In operation 302, the electronic device may set a first load switch target voltage value VCV1 for the constant voltage control of the first load switch (LDSW1) 222, and a second load switch target voltage value VCV2 for the constant voltage control of the second load switch (LDSW2) 232.

According to an embodiment, the first load switch target voltage value VCV1 of the first load switch (LDSW1) 222 may be a value obtained by adding an extra headroom voltage value VHDRM to the fully charged voltage value VFLOAT of the first battery cell 221. The first load switch target voltage value VCV1 may be a target voltage value that is limited not to exceed the first battery cell voltage VB1 when the constant voltage function of the first load switch (LDSW1) 222 operates.

According to an embodiment, the second load switch target voltage value VCV2 of the second load switch (LDSW2) 232 may be a value obtained by adding the extra headroom voltage value VHDRM to the fully charged voltage value VFLOAT of the second battery cell 231. According to an embodiment, when the first battery cell 221 and the second battery cell 231 are battery cells of the same type, the fully charged voltage value VFLOAT of the first battery cell 221 and the second battery cell 231 may be the same. In the disclosure, it is assumed that the fully charged voltage value VFLOAT of the first battery cell 221 and the second battery cell 231 is the same. The second load switch target voltage value VCV2 may be a target voltage value that is limited not to exceed the second battery cell voltage VB2 when the second load switch (LDSW2) 232 operates in the constant voltage function.

In operation 303, the electronic device may set a charger target voltage value VCVT for the constant voltage control of the charger 210 and a charger target current value ICVT for the constant current control of the charger 210.

According to an embodiment, the electronic device may set the target charger voltage value VCVT as the fully charged voltage value VFLOAT of the first battery cell 221 and the second battery cell 231. The charger 210 may maintain the output voltage VCHGO as the charger target voltage value VCVT during the constant voltage operation under the control of the processor 240.

According to an embodiment, the electronic device may set the charger target current value ICVT as a value (ICVT=ICC1+ICC2-IHDRM) obtained by subtracting an extra headroom current value IHDRM from a value obtained by adding the first load switch target current ICC1 of the first load switch 222 to the second load switch target current ICC2 of the second load switch 232. The charger 210 may maintain the output current ICHGO as the charger target current value ICVT during the constant current operation under the control of the processor 240.

In operation 304, the electronic device may control the output current ICHGO of the charger 210 as the constant current such that the output current ICHGO of the charger 210 maintains the target current value ICVT of the charger.

In operation 305, the electronic device may turn on the first load switch (LDSW1) 222 and the second load switch (LDSW2).

In operation 306, the electronic device may determine whether the first battery voltage VB1 is equal to or greater than the second battery voltage VB2.

When it is determined in operation 306 that the first battery voltage VB1 is equal to or greater than the second battery voltage VB2, in operation 307, the electronic device may determine whether the first load switch (LDSW1) 222 is in an on state.

When it is determined in operation 307 that the first load switch (LDSW1) 222 is in the on state, in operation 308, the electronic device may set a reference voltage VSNS, which is a control reference of the output voltage VCHGO of the charger 210, as the first battery voltage VB1. The charger 210 may control the charger 210 with the constant current until the reference voltage VSNS becomes the target voltage value VCVT of the charger. The charger 210 may uniformly maintain the output current ICHGO of the charger as the charger target current ICVT until the reference voltage VSNS becomes the target voltage value VCVT of the charger. The charger 210 may control the charger 210 as the constant voltage when the reference voltage VSNS gradually increases and becomes equal to the target voltage value VCVT of the charger. When the reference voltage VSNS reaches the target voltage value VCVT of the charger 210, the charger 210 may decrease the output current ICHGO of the charger 210 such that the output voltage VCHGO of the charger maintains the target voltage value VCVT of the charger 210. That is, when both the first battery pack 220 and the second battery pack 230 are being charged, the charger 210 may control the output current and the output voltage, based on the battery pack having a higher battery cell voltage.

When it is determined in operation 306 that the first battery voltage VB1 is less than the second battery voltage VB2, or when it is determined in operation 307 that the first load switch (LDSW1) 222 is in an off state, in operation 309, the electronic device may determine whether the second load switch (LDSW2) 232 is in the on state. According to an embodiment, when the first load switch (LDSW1) 222 is in the off state, it may mean that the charging of the first battery cell 221 is completed. According to an embodiment, when it is determined that the first battery cell current IB1 is equal to or greater than a fully charged current I_TOP of the battery cell, the electronic device may block power from being supplied to the first battery cell 221 by turning off the first load switch (LDSW1) 222.

When it is determined in operation 309 that the second load switch LDSW2 is in the on state, in operation 310, the electronic device may set the reference voltage VSNS, which is the control reference of the output voltage VCHGO of the charger 210 as the second battery voltage VB2. The charger 210 may control the charger 210 as the constant current until the reference voltage VSNS becomes the target voltage value VCVT of the charger. The charger 210 may uniformly maintain the output current ICHGO of the charger as the charger target current ICVT until the reference voltage VSNS becomes the target voltage value VCVT of the charger. The charger 210 may control the charger 210 as the constant voltage when the reference voltage VSNS gradually increases and becomes equal to the target voltage value VCVT of the charger. When the reference voltage VSNS reaches the target voltage value VCVT of the charger 210, the charger 210 may decrease the output current ICHGO of the charger 210 such that the output voltage VCHGO of the charger maintains the target voltage value VCVT of the charger 210.

When it is determined in operation 309 that the second load switch LDSW2 is in the off state, since both the first load switch (LDSW1) 222 and the second load switch (LDSW2) 232 are in the off state, the electronic device may end charging in operation 311. According to an embodiment, when the second load switch (LDSW2) 232 is in the off state, it may mean that the charging of the second battery cell 231 is completed. According to an embodiment, when it is determined that the second battery cell current IB2 is equal to or greater than the fully charged current I_TOP of the battery cell, the electronic device may block power from being supplied to the second battery cell 23 by turning off the second load switch (LDSW2) 232. According to an exemplary embodiment, that both the first load switch (LDSW1) 222 and the second load switch (LDSW2) 232 are in the off state may mean that both the first battery cell 221 and the second battery cell 231 are in the fully charged state.

According to an embodiment, after the reference voltage VSNS of the charger 210 is set, in operation 312, the electronic device determines whether the first battery cell current IB1 is equal to or greater than the first load switch target current ICC1, or whether the second battery cell current IB2 is equal to or greater than the second load switch target current ICC2.

For example, when the reference voltage VSNS of the charger 210 is set to the first battery cell voltage VB1, the electronic device may determine whether the first battery cell current IB1 is equal to or greater than the first load switch target current ICC1. As another example, when the reference voltage VSNS is set to the second battery cell voltage VB2, the electronic device may determine whether the second battery cell current IB2 is equal to or greater than the second load switch target current ICC2.

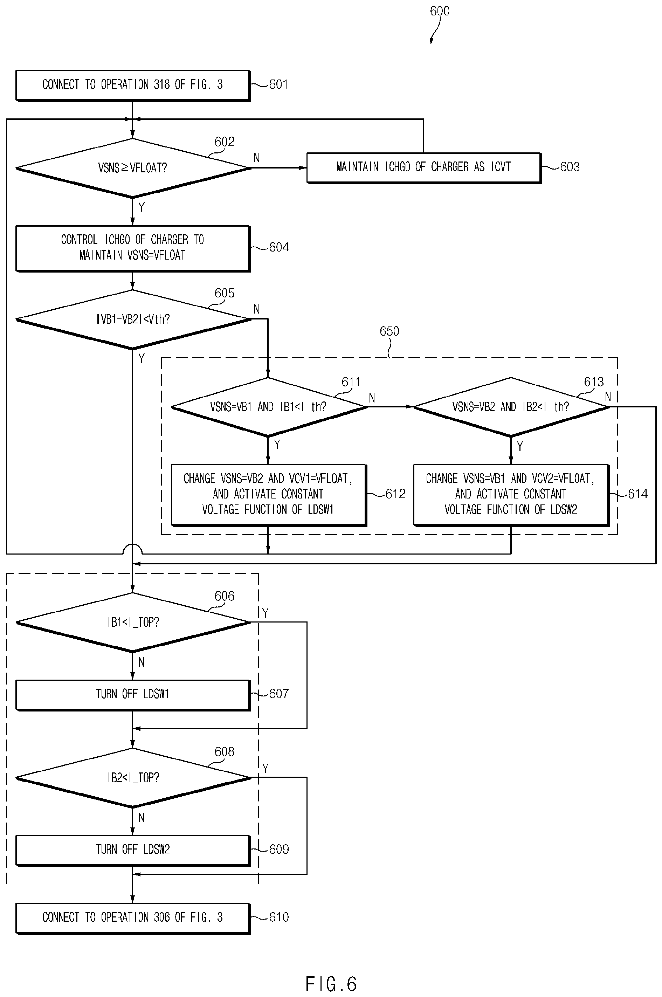

In operation 312, when the electronic device determines that the first battery cell current IB1 is less than the first load switch target current ICC1 or the second battery cell current IB2 is less than the second load switch target current ICC2, the process may move to operation 601 of the flowchart 600 of FIG. 6, which will be described later with reference to FIG. 6.

When the electronic device determines in operation 312 that the first battery cell current IB1 is equal to or greater than the first load switch target current ICC1 or the second battery cell current IB2 is equal to or greater than the second load switch target current ICC2, in operation 313, the electronic device may activate the constant current function of the first load switch LDSW1 or may activate the constant current function of the second load switch LDSW2.

For example, when it is determined in operation 312 that the first battery cell current IB1 is equal to or greater than the first load switch target current ICC1, the electronic device may activate the constant current function of the first load switch (LDSW1) 222. As another example, when it is determined that the second battery cell current IB2 is equal to or greater than the second load switch target current ICC2, the electronic device may activate the constant current function of the second load switch (LDSW2) 232. When the constant current function of the first load switch (LDSW1) 222 is activated, the impedance of the charging path of the first battery cell 221 may be increased to maintain the first battery cell current IB1 below the first load switch target current ICC1. When the constant current function of the second load switch (LDSW2) 232 is activated, the impedance of the charging path of the second battery cell 231 may be increased to maintain the second battery cell current IB2 below the second load switch target current ICC2.

For example, in a structure in which the first battery pack 220 and the second battery pack 230 having the same capacity are connected in parallel, when the impedance of the charging path of the second battery pack 230 is relatively greater than that of the first battery pack 220, the first battery cell current IB1 of the first battery pack 220 having a relatively small impedance of the charging path may be greater than the second battery cell current IB2. As the imbalance of the charging path impedance of the battery cell increases, an asymmetry of the battery cell current may increase, and a current greater than the allowable charging current may be applied to the first battery pack 220. In this case, since the lifetime of the first battery cell 221 may be shortened, the first battery cell current IB1 is limited to an allowable current (e.g., the first load switch target current ICC1) or less, by activating the constant current function of the first load switch (LDSW1) 222.

In operation 314, the electronic device allows the charger target current ICVT of the charger 210 to gradually decrease (ISTEP). Since the charger 210 is under constant current control to output the current uniformly at the charger target current ICVT, the charger target current ICVT may be actually the charger output current ICHGO.

When the constant current function of the first load switch (LDSW1) 222 is activated in operation 313, the voltage drop across both ends of the first load switch (LDSW1) 222 increases, so there is a problem of increased heat generation due to loss, when the constant current function of the first load switch (LDSW1) 222 is activated, the first battery pack 220 may notify the activation of the constant current function to the processor 240, and the processor 240 may allow the target charger current ICVT of the charger 210 to be gradually decreased (ISTEP) until the constant current function of the first load switch (LDSW1) 222 is released.

When the constant current function of the second load switch (LDSW2) 232 is activated in operation 313, the voltage drop across both ends of the second load switch (LDSW2) 232 increases, so there is a problem of increased heat generation due to loss, when the constant current function of the second load switch (LDSW2) 232 is activated, the second battery pack 230 may notify the activation of the constant current function to the processor 240, and the processor 240 may allow the target charger current ICVT of the charger 210 to be gradually decreased (ISTEP) until the constant current function of the second load switch (LDSW2) 232 is released. According to an embodiment, when the heat of the battery pack is less than the reference value, operation 314 may be omitted.

In operation 315, the electronic device may determine whether the first battery cell current IB1 is less than the first load switch target current ICC1 or whether the second battery cell current IB2 is less than the second load switch target current ICC2.

In operation 315, when the first battery cell current IB1 is equal to or greater than the first load switch target current ICC1 or the second battery cell current IB2 is equal to or greater than the second load switch target current ICC2, the electronic device may repeat operation 314 until the first battery cell current IB1 is less than the first load switch target current ICC1 or the second battery cell current IB2 is less than the second load switch target current ICC2.

When the electronic device determines in operation 315 that the first battery cell current IB1 is less than the first load switch target current ICC1 or the second battery cell current IB2 is less than the second load switch target current ICC2, in operation 316, the electronic device may release the constant current function of the first load switch (LDSW1) 222 or the second load switch (LDSW2) 232.

In operation 317, the electronic device may set the charger target current ICVT as a value obtained by subtracting the extra headroom current value IHDRM from a value obtained by adding the first load switch target current ICC1 to the second load switch target current ICC2 of the second load switch 232. After resetting the charger target current ICVT, the electronic device may return to operation 306 and repeat operations in order until the first battery pack 220 and the second battery pack 230 are fully charged.

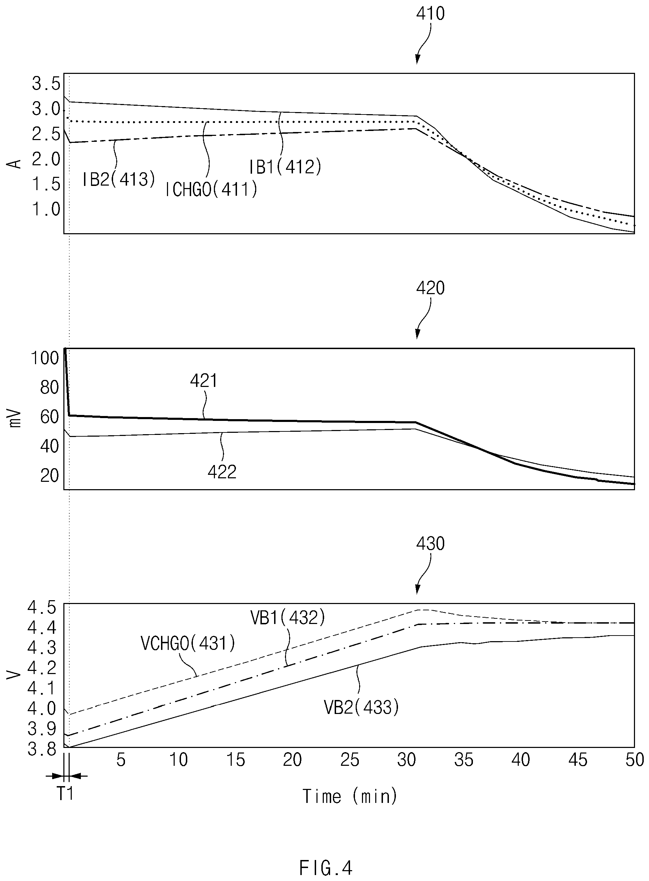

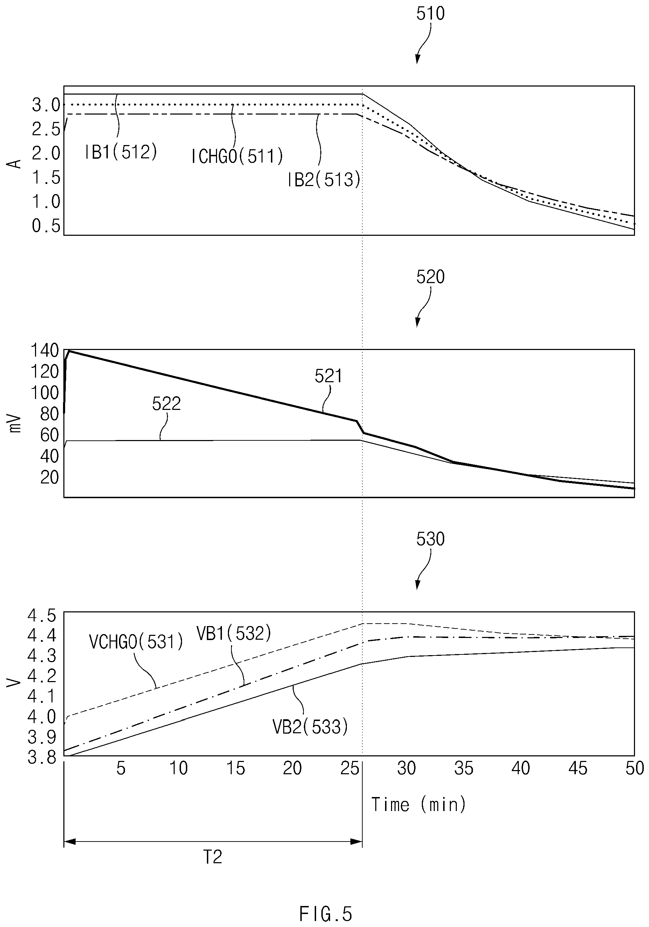

Hereinafter, effects of the electronic device according to an embodiment of the disclosure will be described with reference to FIGS. 4 and 5.

FIG. 4 is graphs 410, 420, and 430 illustrating a battery charging process of an electronic device to which the flowchart 300 of FIG. 3 is applied according to an embodiment of the disclosure.

FIG. 5 is graphs 510, 520, and 530 illustrating a battery charging process in the case of an electronic device to which a first operation section 350 is not applied in the flowchart 300 of FIG. 3 according to an embodiment of the disclosure.

Referring to FIGS. 2 and 4, in the first graph 410 of FIG. 4, an x-axis is time (unit: minutes), and a y-axis is a current magnitude (unit: amperes (A)). In the first graph 410 of FIG. 4, a first current graph 411 may represent the output current ICHGO of the charger 210, the second current graph 412 may represent the first battery cell current IB1, and the third current graph 413 may represent the second battery cell current IB2.

In the second graph 420 of FIG. 4, an x-axis may be time (unit: minutes), and a y-axis may be voltage magnitude (unit: milli volts (mV)). In the second graph 420 of FIG. 4, a first voltage graph 421 may represent the voltage across both ends of the first load switch (LDSW1) 222, and a second voltage graph 422 may represent the voltage across both ends of the second load switch (LDSW2) 232.

In the third graph 430 of FIG. 4, an x-axis may be time (unit: minutes), and a y-axis may be voltage magnitude (unit: volts (V)). In the third graph 430 of FIG. 4, a first voltage graph 431 may represent the output voltage VCHGO of the charger 210, a second voltage graph 432 may represent the first battery cell voltage VB1, and the third voltage graph 433 may represent the second battery cell voltage VB2.

Further referring to FIG. 3, when the electronic device determines that the first battery cell current IB1 is equal to or greater than the first load switch target current ICC1 (e.g., 3.2 A) in operation 312 of FIG. 3, in operation 313, the electronic device may activate the constant current function of the first load switch (LDSW1) 222. As illustrated in a t=0 portion of the second current graph 412 of FIG. 4, since the first battery cell current IB1 is 3.2 A or more, the electronic device may activate the constant current function of the first load switch (LDSW1) 222.

In this case, since the voltage drop across both ends of the first load switch (LDSW1) 222 increases, so there is a problem of increased heat generation due to loss, when the constant current function of the first load switch (LDSW1) 222 is activated, in operation 314 of FIG. 3, the first battery pack 220 may notify the activation of the constant current function to the processor 240, and the processor 240 allow the charger target current ICVT of the charger 210 to be gradually decreased (ISTEP) until the constant current function of the first load switch (LDSW1) 222 is released. Referring to a first section T1 of the first current graph 411 of FIG. 4, it may be seen that the output current ICHGO of the charger 210 gradually decreases.

In operation 315 of FIG. 3, when the first battery cell current IB1 falls below the first load switch target current ICC1 (e.g., 3.2 A), in operation 316, the electronic device may release the constant current function of the first load switch (LDSW1) 222 or the second load switch (LDSW2) 232. Referring to FIG. 4, when the first battery cell current IB1 of the second current graph 412 decreases to less than the first load switch target current ICC1 (e.g., 3.2 A) during the first section T1, it may be confirmed that the constant current function of the first load switch (LDSW1) 222 is released and the output current ICHGO of the charger 210 in the first current graph 411 is controlled as the constant current output again after the first section T1.

Hereinafter, with reference to FIG. 5, a comparative example will be described. FIG. 5 may be graphs illustrating a battery charging process in a case of an electronic device to which a first operation section 350 of FIG. 3 is not applied.

Referring to FIG. 5, in a first graph 510 of FIG. 5, an x-axis may be time (unit: minutes), and a y-axis may be the current magnitude (unit: amperes (A)). In the first graph 510 of FIG. 5, a first current graph 511 may represent the output current ICHGO of the charger 210, a second current graph 512 may represent the first battery cell current IB1, and a third current graph 513 may represent the second battery cell current IB2.

In a second graph 520 of FIG. 5, an x-axis may be time (unit: minutes), and a y-axis may be voltage magnitude (unit: milli volts (mV)). In the second graph 520 of FIG. 5, a first voltage graph 521 may represent the voltage across both ends of the first load switch (LDSW1) 222, and a second voltage graph 522 may represent the voltage across both ends of the second load switch (LDSW2) 232.

In a third graph 530 of FIG. 5, an x-axis may be time (unit: minutes), and a y-axis may be voltage magnitude (unit: volts (V)). In the third graph 530 of FIG. 5, a first voltage graph 531 may represent the output voltage VCHGO of the charger 210, a second voltage graph 532 may represent the first battery cell voltage VB1, and the third voltage graph 533 may represent the second battery cell voltage VB2.

Referring to the first graph 510 of FIG. 5, at t=0 of the second current graph 512, since the first battery cell current IB1 is 3.2 A or more, the electronic device may activate the constant current function of the first load switch (LDSW1) 222, but as illustrated in the first current graph 511, and it may be seen that the charger output current ICHGO is maintained to the charger target current ICVT (e.g., 3.0 A) as the constant current output without gradually decreasing (ISTEP) the charger target current ICVT of the charger 210, unlike FIG. 4. The reference voltage VSNS of the charger 210 is set to the first battery cell current VB1 greater than the second battery cell current VB2, and the electronic device may maintain the constant current control of the first load switch (LDSW1) 222 until the first battery cell current VB1, which is the reference voltage VSNS of the charger 210 becomes equal to the target voltage value VCVT (e.g., 4.3 V) of the charger. Therefore, referring to the first voltage graph 521 of the second graph 520, since the voltage drop across both ends of the first load switch (LDSW1) 222 occurs during a second section T2 longer than the first section T1 of FIG. 4, a problem of increased heat generation due to loss may occur.

That is, according to the electronic device according to an embodiment of the disclosure, when the first battery pack 220 and the second battery pack 230 having different impedances of the charging paths are charged with one charger 210, it is possible to prevent the occurrence of overcurrent and overvoltage due to the asymmetry of charging current, thereby preventing shortening of battery lifetime.

Hereinafter, an operation of an electronic device including the circuit diagram 200 for charging the battery of FIG. 2 will be described with reference to FIG. 6.

FIG. 6 is a flowchart 600 illustrating an operation of an electronic device including the circuit diagram 200 for charging a battery of FIG. 2 according to an embodiment of the disclosure.

Referring to FIGS. 2 and 6, the flowchart 600 of FIG. 6 in operation 601 may start in connection with operation 318 of the flowchart 300 of FIG. 3.

In operation 602, the electronic device may determine whether the reference voltage VSNS of the charger 210 is equal to or greater than the fully charged voltage VFLOAT of the battery cell. In the disclosure, it is assumed that the fully charged voltages of the first battery cell 221 and the second battery cell 231 are the same, and the fully charged voltage VFLOAT of the battery cell may be the fully charged voltage the first battery cell 221 or the second battery cell 231.

When it is determined in operation 602 that the reference voltage VSNS of the charger 210 is less than the fully charged voltage VFLOAT of the battery cell, in operation 603, the electronic device determines that the reference voltage VSNS of the charger 210 may maintain the output current ICHGO of the charger 210 at the charger target current ICVT (constant current control) until the reference voltage VSNS of the charger 210 is greater than or equal to the fully charged voltage VFLOAT of the battery cell.

When it is determined in operation 602 that the reference voltage VSNS of the charger 210 is equal to or greater than the fully charged voltage VFLOAT of the battery cell, in operation 604, the electronic device may control the output current ICHGO of the charger 210 such that the reference voltage VSNS maintains (the constant voltage control) the fully charged voltage VFLOAT.

In operation 605, the electronic device may determine whether a difference between the first battery cell voltage VB1 and the second battery cell voltage VB2 is less than a threshold voltage value Vth. For example, the processor 240 may receive the first battery cell voltage VB1 from the first constant current/constant voltage controller 226 or the first voltage sensing circuit 224 of the first battery pack 220, may receive the second battery cell voltage VB2 from the second constant current/constant voltage controller 236 or the second voltage sensing circuit 234 of the second battery pack 230, and may determine whether the difference between the first battery cell voltage VB1 and the second battery cell voltage VB2 is less than the threshold voltage value Vth.

When it is determined in operation 605 that the difference between the first battery cell voltage VB1 and the second battery cell voltage VB2 is less than the threshold voltage value Vth, in operation 606 the electronic device may determine that the first battery cell current IB1 is less than the fully charged current I_TOP of the battery cell.

When it is determined in operation 606 that the first battery cell current IB1 is equal to or greater than the fully charged current I_TOP of the battery cell, since charging of the first battery cell 221 is completed, in operation 607, the electronic device may turn off the first load switch (LDSW1) 222, and may proceed to operation 608. When it is determined in operation 606 that the first battery cell current IB1 is less than the fully charged current I_TOP of the battery cell, since the first battery cell 221 has not yet been fully charged, the electronic device may proceed directly to operation 608 without turning off the first load switch (LDSW1) 222.

In operation 608, the electronic device may determine whether the second battery cell current IB2 is less than the fully charged current I_TOP of the battery cell.

In operation 608, when it is determined that the second battery cell current IB2 is equal to or greater than the fully charged current I_TOP of the battery cell, since charging of the second battery cell 231 is completed, in operation 609, the electronic device may turn off the second load switch (LDSW2) 232 and may proceed to operation 610. When it is determined in operation 608 that the second battery cell current IB2 is less than the fully charged current I_TOP of the battery cell, since the second battery cell 231 has not yet been fully charged, the electronic device may proceed directly to operation 610 without turning off the second load switch (LDSW2) 232.

In operation 610, the electronic device may be connected to operation 306 of FIG. 3. According to the operations of the flowchart 300 of FIG. 3, the electronic device connected to operation 306 of FIG. 3 may use the battery cell voltage of the battery pack having a higher battery cell voltage as the reference voltage VSNS, and then may uniformly control the output current ICHGO of the charger to the charger target current ICVT through the constant current control until the reference voltage VSNS reaches the target voltage value VCVT of the charger, and when the reference voltage VSNS gradually increases by charging and becomes equal to the target voltage value VCVT of the charger, the electronic device may control the charger 210 as the constant voltage such that the output voltage VCHGO of the charger maintains the target voltage value VCVT of the charger. When one load switch is turned off by the second operation section 360 of FIG. 3, the electronic device may change the reference voltage VSNS of the charger to another battery cell voltage to control the charger 210 until charging is complete.

Referring back to operation 611 of FIG. 6, when the electronic device determines in operation 605 that the difference between the first battery cell voltage VB1 and the second battery cell voltage VB2 is equal to or greater than the threshold voltage value Vth, in operation 611, it may be determined whether the reference voltage VSNS of the charger 210 as of now is the first battery cell voltage VB1 and the first battery cell current IB1 is less than a threshold current value Ith. According to an embodiment, the threshold current value Ith may be a maximum current value that allows the heat generation of the load switch to be maintained within an allowable range even if the load switch activates the constant voltage function by increasing the resistance. The threshold current value Ith may be set at the time of designing the battery pack, and may typically be 1 A (ampere) or less.

When it is determined in operation 611 that the reference voltage VSNS of the charger 210 is the first battery cell voltage VB1 and the first battery cell current IB1 is less than the threshold current value Ith, in operation 612, the electronic device may change the reference voltage VSNS to the second battery cell voltage VB2, may set the first load switch target voltage value VCV1 to the fully charged voltage VFLOAT of the battery cell, and may activate the first load switch (LDSW1) 222.

For example, in the second battery cell 231 having a higher impedance of the charging path than the first battery cell 221, the second battery cell voltage VB2 may not increase beyond a certain level, until the first battery cell 221 is fully charged and the charging of the first battery cell 221 is cut off. In this case, since the charging of the second battery cell 231 is delayed, the electronic device may change the reference voltage VSNS of the charger 210 to the second battery cell voltage VB2 in operation 612 to prevent the charging delay of the second battery cell 231. In addition, in this case, since the first battery cell voltage VB1 is not the reference voltage VSNS of the charger 210, an overvoltage problem of the first battery cell voltage VB1 may occur. To prevent this, the electronic device may activate the constant voltage function of the first load switch (LDSW1) 222 in operation 612.

In operation 612, after the electronic device changes the reference voltage VSNS to the second battery cell voltage VB2, sets the first load switch target voltage value VCV1 to the fully charged voltage VFLOAT of the battery cell, and activates the constant voltage function of the first load switch (LDSW1) 222, the electronic device may return to operation 602 and may maintain the charging until the fully charged voltage VFLOAT is reached based on the changed reference voltage VSNS (= the second battery cell voltage VB2).

In operation 611 again, when it is determined that a condition that the reference voltage VSNS of the charger 210 as of now is the first battery cell voltage VB1 and the first battery cell current IB1 is less than the threshold current value Ith is not satisfied, in operation 613, the electronic device may determine whether the reference voltage VSNS of the charger 210 as of now is the second battery cell voltage VB2 and the second battery cell current IB2 is less than the threshold current value Ith.

When it is determined in operation 613 that the reference voltage VSNS of the charger 210 as of now is the second battery cell voltage VB2 and the second battery cell current IB2 is less than the threshold current value Ith, in operation 614, the electronic device may change the reference voltage VSNS to the first battery cell voltage VB1, may set the second load switch target voltage value VCV2 to the fully charged voltage VFLOAT of the battery cell, and may activate the constant voltage function of the second load switch (LDSW2) 232.

For example, in operation 614, the electronic device may change the reference voltage VSNS of the charger 210 to the first battery cell voltage VB1 so as to prevent the charging delay of the first battery cell 221, and may activate the constant voltage function of the second load switch (LDSW2) 232 so as to prevent the overvoltage problem of the second battery cell voltage VB2.

In operation 614, the electronic device changes the reference voltage VSNS to the first battery cell voltage VB2, sets the second load switch target voltage value VCV2 to the fully charged voltage VFLOAT of the battery cell, and activates the constant voltage function of the second load switch (LDSW2) 232, and then the electronic device returns to operation 602 may return to operation 602 and may maintain the charging until the fully charged voltage VFLOAT is reached based on the changed reference voltage VSNS (= the first cell voltage VB1).

In operation 613 again, it is determined that a condition that the reference voltage VSNS of the charger 210 as of now is the second battery cell voltage VB2 and the second battery cell current IB2 is less than the threshold current value Ith is not satisfied, the electronic device may move to operation 606 without using the constant voltage function of the load switch (e.g., the first load switch LDSW1 and/or the second load switch LDSW2).

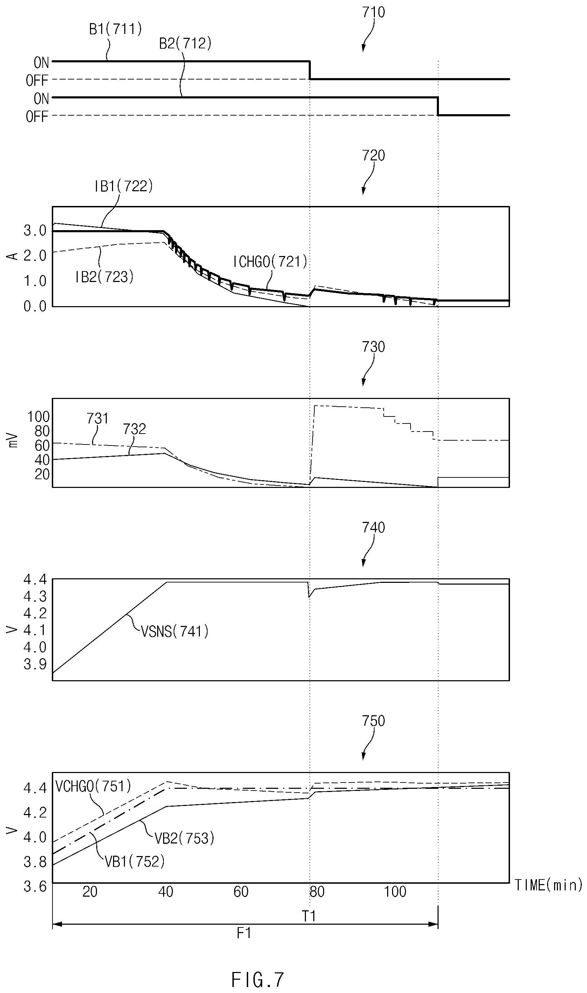

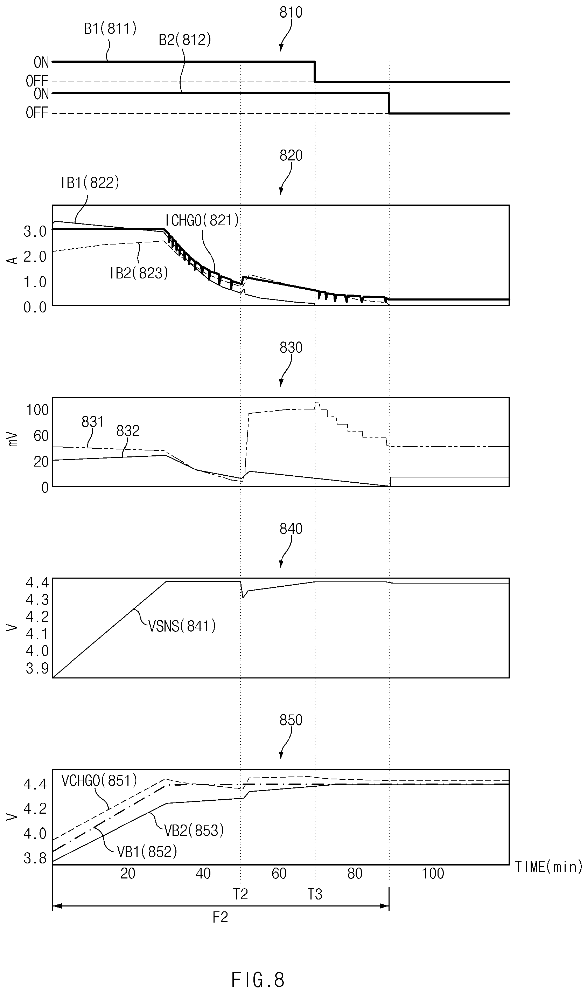

Hereinafter, effects of the electronic device according to an embodiment of the disclosure will be described with reference to FIGS. 7 and 8.

FIG. 7 is graphs 710, 720, 730, 740, and 750 illustrating a battery charging process in the case of an electronic device to which the first operation section 650 is not applied in the flowchart 600 of FIG. 6 according to an embodiment of the disclosure.

FIG. 8 is graphs 810, 820, 830, 840, and 850 illustrating a battery charging process of an electronic device to which the flowchart 600 of FIG. 6 is applied according to an embodiment of the disclosure.

Referring to FIGS. 2 and 7, in the first graph 710 of FIG. 7, an x-axis may represent time (unit: minutes), and a y-axis may represent charging on/off of the battery pack. A first charging graph 711 of the first graph 710 may indicate whether the first battery pack 220 is charged, and a second charging graph 712 may indicate whether the second battery pack 230 is charged.

In the second graph 720 of FIG. 7, an x-axis may represent time (unit: minutes), and a y-axis may represent current magnitude (unit: amperes (A)). A first current graph 721 of the second graph 720 may represent the output current ICHGO of the charger 210, a second current graph 722 may represent the first battery cell current IB1, and a third current graph 723 may represent the second battery cell current IB2.

In the third graph 730 of FIG. 7, an x-axis may be time (unit: minutes), and a y-axis may be voltage magnitude (unit: milli volts (mV)). A first voltage graph 731 of the third graph 730 of FIG. 7 may represent the voltage across both ends of the first load switch (LDSW1) 222, and a second voltage graph 732 may represent the voltage across both ends of the second load switch (LDSW2) 232.

In the fourth graph 740 of FIG. 7, an x-axis may be time (unit: minutes), and a y-axis may be voltage magnitude (unit: volts (V)). A voltage graph 741 of the fourth graph 740 of FIG. 7 may represent the reference voltage VSNS of the charger 210.

In the fifth graph 750 of FIG. 7, an x-axis may be time (unit: minutes), and a y-axis may be voltage magnitude (unit: volts (V)). A first voltage graph 751 of the fifth graph 750 may indicate the output voltage VCHGO of the charger 210, a second voltage graph 752 may indicate the first battery cell voltage VB1, and a third voltage graph 753 may indicate the second battery cell voltage VB2.

When the charging is started, the electronic device set a voltage having a larger value among the first battery cell voltage VB1 and the second battery cell voltage VB2 as the reference voltage VSNS, and may uniformly output the output voltage ICHGO of the charger 210 to the charger target current ICVT as the constant current until the reference voltage VSNS becomes equal to the fully charged voltage VFLOAT. Comparing the second voltage graph 752 and the third voltage graph 753 of the fifth graph 750, the first battery cell voltage VB1 is greater, so that the electronic device may set the first battery cell voltage VB1 to the reference voltage VSNS, and when referring to the voltage graph 741 of the fourth graph 740 and the first current graph 721 of the second graph 720, the output current ICHGO of the charger 210 may be controlled as the constant current to the charger target current ICVT (e.g., 3.0 A) until the reference voltage VSNS reaches the fully charged voltage VFLOAT (e.g., 4.4 V).

When the reference voltage VSNS reaches the fully charged voltage VFLOAT, the electronic device may control the charger 210 to the constant voltage such that the reference voltage VSNS maintains the fully charged voltage VFLOAT. Referring to the second voltage graph 752 of the fifth graph 750 and the first current graph 721 of the second graph 720 of FIG. 7, when the first battery cell voltage VB1 which is the reference voltage VSNS is reached to the fully charged voltage VFLOAT (e.g., 4.4 V), the output current ICHGO of the charger 210 may be decreased such that the reference voltage VSNS maintains the fully charged voltage VFLOAT.

When the charging of the first battery cell 221 is completed, the electronic device may block the charging of the first battery cell 221 and may convert the reference voltage VSNS of the charger 210 to the second battery cell voltage VB2, and control the charger 210 until the charging of the second battery cell 231 is completed. Referring to the first charging graph 711 in the first graph 710 and the voltage graph 741 in the fourth graph 740 of FIG. 7, when the first battery cell 221 is fully charged and the charging is cut off at the first time T1, the electronic device may change the reference voltage VSNS of the charger 210 to the second battery cell voltage VB2. The electronic device may perform the constant current control of the charger 210 until the second battery cell voltage VB2, which is the reference voltage VSNS, reaches the fully charged voltage VFLOAT (e.g., 4.4 V), and then may perform the constant voltage control of the charger 210 and may block the charging when the charging of the second battery cell 231 is completed

Referring to FIG. 7, a first period F1 may be taken until charging of the first battery cell 221 and the second battery cell 231 are all completed. Referring to the third voltage graph 753 of the fifth graph 750, the second battery cell voltage VB2 may not increase more than a specific level until the first battery cell 221 is fully charged and the charging of the first battery cell 221 is cut off (until the first time T1). Accordingly, referring to the third current graph 723 of the second graph 720, after the first battery cell 221 is fully charged and the charging of the first battery cell 221 is cut off (the first time T1), as the second battery cell current IB2 increases, the charging is possible until the full charge is reached, and the time may be delayed until the charging of the second battery cell 231 is completely completed.

In contrast, the effect of the electronic device to which the flowchart 600 of FIG. 6, in particular, the first operation section 650 is applied will be described with reference to FIG. 8 below.

Referring to FIGS. 2 and 8, in the first graph 810 of FIG. 8, an x-axis may represent time (unit: minutes), and a y-axis may represent charging on/off of the battery pack. A first charging graph 811 of the first graph 810 may indicate whether the first battery pack 220 is charged, and a second charging graph 812 may indicate whether the second battery pack 230 is charged.

In the second graph 820 of FIG. 8, an x-axis may represent time (unit: minutes), and a y-axis may represent current magnitude (unit: amperes (A)). A first current graph 821 of the second graph 820 may represent the output current ICHGO of the charger 210, a second current graph 822 may represent the first battery cell current IB1, and a third current graph 823 may represent the second battery cell current IB2.

In the third graph 830 of FIG. 8, an x-axis may be time (unit: minutes), and a y-axis may be voltage magnitude (unit: milli volts (mV)). A first voltage graph 831 of the third graph 830 of FIG. 8 may represent the voltage across both ends of the first load switch (LDSW1) 222, and a second voltage graph 832 may represent the voltage across both ends of the second load switch (LDSW2) 232.

In the fifth graph 850 of FIG. 8, an x-axis may be time (unit: minutes), and a y-axis may be voltage magnitude (unit: volts (V)). A first voltage graph 851 of the fifth graph 850 may indicate the output voltage VCHGO of the charger 210, a second voltage graph 852 may indicate the first battery cell voltage VB1, and a third voltage graph 853 may indicate the second battery cell voltage VB2.

Referring to FIGS. 6 and 8, the operation until the second time T2 may be the same as described above with reference to FIG. 7. In the graphs 810, 820, 830, 840, and 850 of FIG. 8, before the second time T2, the reference voltage VSNS of the charger 210 is set to the second battery cell voltage VB2, and the section in which the output current ICHGO of the charger 210 is controlled as a constant current output until the reference voltage VSNS reaches the fully charged voltage VFLOAT may correspond to operations 602 and 603 of FIG. 6. When the reference voltage VSNS reaches fully charged voltage VFLOAT, the section in which the output current ICHGO is controlled as the constant voltage such that the reference voltage VSNS of the charger 210 maintains the fully charged voltage VFLOAT may correspond to operations 602 and 604 of FIG. 6.

Unlike FIG. 7, in FIG. 8, in operation 605 of FIG. 6, a difference between the first battery cell voltage VB1 and the second battery cell voltage VB2 is equal to or greater than the threshold voltage value Vth, and in operation 611, and, in operation 611, when a condition that the reference voltage VSNS is the first battery cell voltage VB1 and the first battery cell current IB1 is less than the threshold current value Ith is satisfied, in operation 612, the reference voltage VSNS may be changed to the second battery cell voltage VB2, the first load switch target voltage value VCV1 may be set to the fully charged voltage VFLOAT of the battery cell, and the constant voltage function of the first load switch (LDSW1) 222 may be activated.

Referring to a voltage graph 841 of the fourth graph 840 of FIG. 8, it may be seen that the reference voltage VSNS is changed from the first battery cell voltage VB1 to the second battery cell voltage VB2 at the second time T2, and referring to a second voltage graph 852 of the fifth graph 850, it may be seen that the first battery cell voltage VB1 is maintained at the constant voltage even after the second time T2. Therefore, referring to a third voltage graph 853 of the fifth graph 850, unlike FIG. 7, even before the first battery cell 221 is fully charged (before a third time T3), the second battery cell voltage VB2 may increase to the fully charged voltage VFLOAT (e.g., 4.4 V), and the fully charging of the second battery cell 231 do not delay and the second period F2 required until the charging of both the first battery cell 221 and the second battery cell 231 is completed may be shorter than the first period F1 of FIG. 7.

That is, the electronic device according to an embodiment of the disclosure, when charging with one charger, and including two or more batteries (e.g., the first battery pack 220 and the second battery pack 230) connected in parallel to each other, may prevent overcurrent and overvoltage due to asymmetry of the charging currents of the batteries, may prevent shortening of battery lifetime, and may decrease the time required for all batteries to be fully charged.

The electronic device 101 according to an embodiment of the disclosure includes the charger 210, the first battery pack 220 electrically connected to the charger through a first path, the second battery pack 230 electrically connected to the charger through a second path having an impedance greater than that of the first path, and the processor 240 electrically connected to the charger, the first battery pack, and the second battery pack. The processor is configured to activate a constant current function of a first load switch included in the first battery pack (operation 313) when a first condition is satisfied, and to allow the charger to decrease an output current of the charger (operation 314) until the constant current function of the first load switch is deactivated.

According to an embodiment of the disclosure, the first battery pack 220 may include the first battery cell 221, the first load switch 222, the third load switch 223, and the first voltage sensing circuit 224 that senses a first battery cell voltage applied to both ends of the cell, and the first current sensing circuit 225 that senses a first battery cell current flowing in a node positioned between the first load switch and the third load switch, and the second battery pack 230 may include the second battery cell 231, the second load switch 232, the fourth load switch 233, the second voltage sensing circuit 234 that senses a second battery cell voltage applied to both ends of the second battery cell, and the second current sensing circuit 235 that senses a second battery cell current flowing in a node positioned between the second load switch and the fourth load switch.

According to an embodiment of the disclosure, the first condition may be whether the first battery cell current is equal to or greater than the maximum allowable current of the first battery cell (operation 312), and the processor may activate the constant current function of the first load switch included in the first battery pack (operation 313) in response to determining that the first battery cell current is equal to or greater than the maximum allowable current of the first battery cell.

According to an embodiment of the disclosure, the first load switch may allow the first battery cell current to be less than the maximum allowable current of the first battery cell when the constant current function of the first load switch of the first battery pack is activated.

According to an embodiment of the disclosure, the processor may allow the constant current function of the first load switch to be deactivated (operation 316) when the first battery cell current is less than the maximum allowable current of the first battery cell (operation 315).

According to an embodiment of the disclosure, the processor may be configured to allow a reference voltage of the charger to be changed from the first battery cell voltage to the second battery cell voltage (operations 612 and 614) in response to a second condition being satisfied.

According to an embodiment of the disclosure, the second condition may be whether a difference between the first battery cell voltage and the second battery cell voltage is equal to or greater than a threshold voltage value (operation 605).

According to an embodiment of the disclosure, the processor may be configured to set a target voltage value of the first load switch to a fully charged voltage of the first battery cell and to activate the constant voltage function of the first load switch (operations 612 and 614) when the second condition is satisfied.

According to an embodiment of the disclosure, the processor may be configured to determine the reference voltage of the charger as a greater value of the first battery cell voltage and the second battery cell voltage (operations 306, 308, and 309), when the second condition is not satisfied.

According to an embodiment of the disclosure, the processor may be configured to control the output current of the charger as a constant current until the reference voltage of the charger reaches a target voltage value of the charger (operation 604), and to control the output current of the charger as a constant voltage such that the reference voltage is maintained at the target voltage value of the charger when the reference voltage reaches the target voltage value of the charger (operation 603), and the target voltage value of the charger may be a fully charged voltage of the first battery cell or the second battery cell.

According to an embodiment of the disclosure, a method of charging a battery of the electronic device 101 including the charger 210, the first battery pack 220 electrically connected to the charger through a first path, and the second battery pack 230 electrically connected to the charger through a second path having a higher impedance than the first path, includes activating, by the processor 240 of the electronic device 101, a constant current function of a first load switch included in the first battery pack when a first condition is satisfied (operation 313), and allowing, by the processor, the charger to decrease an output current of the charger (operation 314) until the constant current function of the first load switch is deactivated.

According to an embodiment of the disclosure, the first battery pack 220 may include the first battery cell 221, the first load switch 222, the third load switch 223, the first voltage sensing circuit 224 that senses a first battery cell voltage applied to both ends of the first battery cell, and the first current sensing circuit 225 that senses a first battery cell current flowing in a node positioned between the first load switch and the third load switch, and the second battery pack 230 may include the second battery cell 231, the second load switch 232, the fourth load switch 233, the second voltage sensing circuit 234 that senses a second battery cell voltage applied to both ends of the second battery cell, and the second current sensing circuit 235 that senses a second battery cell current flowing in a node positioned between the second load switch and the fourth load switch.

According to an embodiment of the disclosure, the first condition may be whether the first battery cell current is equal to or greater than the maximum allowable current of the first battery cell (operation 312), and the constant current function of the first load switch included in the first battery pack may be activated (operation 313) in response to determining that the first battery cell current is equal to or greater than the maximum allowable current of the first battery cell.

According to an embodiment of the disclosure, the first load switch may allow the first battery cell current to be less than the maximum allowable current of the first battery cell when the constant current function of the first load switch of the first battery pack is activated.

According to an embodiment of the disclosure, the processor may allow the constant current function of the first load switch to be deactivated (operation 315) when the first battery cell current is less than the maximum allowable current of the first battery cell (operation 315).

According to an embodiment of the disclosure, the processor may allow a reference voltage of the charger to be changed from the first battery cell voltage to the second battery cell voltage (operations 612 and 614) in response to a second condition being satisfied.

According to an embodiment of the disclosure, the second condition may be whether a difference between the first battery cell voltage and the second battery cell voltage is equal to or greater than a threshold voltage value (operation 605).

According to an embodiment of the disclosure, the processor may set a target voltage value of the first load switch to a fully charged voltage of the first battery cell and may activate the constant voltage function of the first load switch (operations 612 and 614) when the second condition is satisfied.

According to an embodiment of the disclosure, the processor may determine the reference voltage of the charger as a greater value of the first battery cell voltage and the second battery cell voltage (operations 306, 308, and 309), when the second condition is not satisfied.

According to an embodiment of the disclosure, the processor may control the output current of the charger as a constant current until the reference voltage of the charger reaches a target voltage value of the charger (operation 604), and may control the output current of the charger as a constant voltage such that the reference voltage is maintained at the target voltage value of the charger when the reference voltage reaches the target voltage value of the charger (operation 603), and the target voltage value of the charger may be a fully charged voltage of the first battery cell or the second battery cell.

## Claims

1. An electronic device comprising:
a charger (210);
a first battery pack (220) electrically connected to the charger (210) through a first path;
a second battery pack (230) electrically connected to the charger (210) through a second path having a higher impedance than the first path;
wherein the first battery pack (220) includes a first battery cell (221), a first load switch (222), and a first current sensing circuit (225) that senses a first battery cell current (IB 1) flowing through the first load switch (222); and
a processor (240) electrically connected to the charger (210), the first battery pack (220), and the second battery pack (230),
**characterized in that**,
the processor (240) is configured to:
activate a constant current function of the first load switch (222) included in the first battery pack (220) when the first battery cell current (IB1) is equal to or greater than a maximum allowable current (ICC1) of the first battery cell (221),
allow the charger (210) to decrease an output current (ICHGO) of the charger (210) until the constant current function of the first load switch (222) is deactivated when the first battery cell current (IB1) is less than the maximum allowable current (ICC1) of the first battery cell (221).

2. The electronic device of claim 1,
wherein the first battery pack (220) includes a first voltage sensing circuit (224) that senses a first battery cell voltage (VB1) applied to both ends of the first battery cell (221), and
wherein the second battery pack (230) includes a second battery cell (231), a second load switch (232), a second voltage sensing circuit (234) that senses a second battery cell voltage (VB2) applied to both ends of the second battery cell (231), and a second current sensing circuit (235) that senses a second battery cell current (IB2) flowing through the second load switch (232).

3. The electronic device of claim 2, wherein the first load switch (222) allows the first battery cell current (IB 1) to be less than a maximum allowable current (ICC1) of the first battery cell (221) when the constant current function of the first load switch (222) of the first battery pack (220) is activated.

4. The electronic device of claim 2, wherein the processor (240) is configured to allow a reference voltage (VSNS) of the charger (210) to be changed from the first battery cell voltage (VB1) to the second battery cell voltage (VB2) in response to a condition being satisfied.

5. The electronic device of claim 4, wherein the condition is whether a difference between the first battery cell voltage (VB1) and the second battery cell voltage (VB2) is equal to or greater than a threshold voltage value (Vth).

6. The electronic device of claim 4, wherein the processor (240) is configured to:
set a target voltage value (VCVT) of the first load switch (222) to a fully charged voltage (VFLOAT) of the first battery cell (221); and
activate a constant voltage function of the first load switch (222) when the condition is satisfied.

7. The electronic device of claim 4, wherein the processor (240) is configured to determine the reference voltage (VSNS) of the charger (210) as a greater value of the first battery cell voltage (VB1) and the second battery cell voltage (VB2), when the condition is not satisfied.

8. The electronic device of claim 4,
wherein the processor (240) is configured to:
control the output current (ICHGO) of the charger (210) as a constant current until the reference voltage (VSNS) of the charger (210) reaches a target voltage value (VCVT) of the charger (210), and
control the output current (ICHGO) of the charger (210) as a constant voltage such that the reference voltage (VSNS) is maintained at the target voltage value (VCVT) of the charger (210) when the reference voltage (VSNS) reaches the target voltage value (VCVT) of the charger (210), and
wherein the target voltage value (VCVT) of the charger (210) is a fully charged voltage (VFLOAT) of the first battery cell (221) or the second battery cell (231).

9. A method of charging a battery of an electronic device including a charger (210), a first battery pack (220) electrically connected to the charger (210) through a first path, and a second battery pack (230) electrically connected to the charger (210) through a second path having a higher impedance than the first path, wherein the first battery pack (220) includes a first battery cell (221), a first load switch (222), and a first current sensing circuit (225) that senses a first battery cell current (IB1) flowing through the first load switch (222), the method comprising:
activating, by a processor (240) of the electronic device, a constant current function of the first load switch (222) included in the first battery pack (220) when the first battery cell current (IB1) is equal to or greater than a maximum allowable current (ICC1) of the first battery cell (221); and
allowing, by the processor (240), the charger (210) to decrease an output current (ICHGO) of the charger (210) until the constant current function of the first load switch (222) is deactivated when the first battery cell current (IB1) is less than the maximum allowable current (ICC1) of the first battery cell (221).

10. The method of claim 9,
wherein the first battery pack (220) includes a first voltage sensing circuit (224) that senses a first battery cell voltage (VB1) applied to both ends of the first battery cell (221), and
wherein the second battery pack (230) includes a second battery cell (231), a second load switch (232), a second voltage sensing circuit (234) that senses a second battery cell voltage (VB2) applied to both ends of the second battery cell (231), and a second current sensing circuit (235) that senses a second battery cell current (IB2) flowing through the second load switch (232).

11. The method of claim 10, wherein the first load switch (222) allows the first battery cell current (IB1) to be less than a maximum allowable current (ICC1) of the first battery cell (221) when the constant current function of the first load switch (222) of the first battery pack (220) is activated.

## Patentansprüche

1. Elektronische Vorrichtung, umfassend:
ein Ladegerät (210);
einen ersten Batteriepack (220), der über einen ersten Pfad elektrisch mit dem Ladegerät (210) verbunden ist;
einen zweiten Batteriepack (230), der über einen zweiten Pfad elektrisch mit dem Ladegerät (210) verbunden ist, wobei der zweite Pfad eine höhere Impedanz als der erste Pfad aufweist;
wobei der erste Batteriepack (220) eine erste Batteriezelle (221), einen ersten Lastschalter (222) und eine erste Stromerfassungsschaltung (225) umfasst, die einen durch den ersten Lastschalter (222) fließenden ersten Batteriezellenstrom (IB1) erfasst; und
einen Prozessor (240), der elektrisch mit dem Ladegerät (210), dem ersten Batteriepack (220) und dem zweiten Batteriepack (230) verbunden ist,
**dadurch gekennzeichnet, dass**
der Prozessor (240) dazu konfiguriert ist:
eine Konstantstromfunktion des im ersten Batteriepack (220) enthaltenen ersten Lastschalters (222) zu aktivieren, wenn der erste Batteriezellenstrom (IB1) gleich oder größer als ein maximal zulässiger Strom (ICC1) der ersten Batteriezelle (221) ist,
zu ermöglichen, dass das Ladegerät (210) einen Ausgangsstrom (ICHGO) des Ladegeräts (210) verringert, bis die Konstantstromfunktion des ersten Lastschalters (222) deaktiviert wird, wenn der erste Batteriezellenstrom (IB1) kleiner als der maximal zulässige Strom (ICC1) der ersten Batteriezelle (221) ist.

2. Elektronische Vorrichtung nach Anspruch 1,
wobei der erste Batteriepack (220) eine erste Spannungserfassungsschaltung (224) umfasst, die eine an beiden Enden der ersten Batteriezelle (221) anliegende erste Batteriezellenspannung (VB1) erfasst, und
wobei der zweite Batteriepack (230) eine zweite Batteriezelle (231), einen zweiten Lastschalter (232), eine zweite Spannungserfassungsschaltung (234), die eine an beiden Enden der zweiten Batteriezelle (231) anliegende zweite Batteriezellenspannung (VB2) erfasst, und eine zweite Stromerfassungsschaltung (235) umfasst, die einen durch den zweiten Lastschalter (232) fließenden zweiten Batteriezellenstrom (IB2) erfasst.

3. Elektronische Vorrichtung nach Anspruch 2, wobei der erste Lastschalter (222) ermöglicht, dass der erste Batteriezellenstrom (IB1) kleiner als ein maximal zulässiger Strom (ICC1) der ersten Batteriezelle (221) ist, wenn die Konstantstromfunktion des ersten Lastschalters (222) des ersten Batteriepacks (220) aktiviert ist.

4. Elektronische Vorrichtung nach Anspruch 2, wobei der Prozessor (240) dazu konfiguriert ist, zu ermöglichen, dass eine Referenzspannung (VSNS) des Ladegeräts (210) in Reaktion auf das Erfülltsein einer Bedingung von der ersten Batteriezellenspannung (VB1) auf die zweite Batteriezellenspannung (VB2) geändert wird.

5. Elektronische Vorrichtung nach Anspruch 4, wobei die Bedingung darin besteht, ob eine Differenz zwischen der ersten Batteriezellenspannung (VB1) und der zweiten Batteriezellenspannung (VB2) gleich oder größer als ein Schwellenspannungswert (Vth) ist.

6. Elektronische Vorrichtung nach Anspruch 4, wobei der Prozessor (240) dazu konfiguriert ist:
einen Zielspannungswert (VCVT) des ersten Lastschalters (222) auf eine vollständig geladene Spannung (VFLOAT) der ersten Batteriezelle (221) einzustellen; und
eine Konstantspannungsfunktion des ersten Lastschalters (222) zu aktivieren, wenn die Bedingung erfüllt ist.

7. Elektronische Vorrichtung nach Anspruch 4, wobei der Prozessor (240) dazu konfiguriert ist, die Referenzspannung (VSNS) des Ladegeräts (210) als einen größeren Wert der ersten Batteriezellenspannung (VB1) und der zweiten Batteriezellenspannung (VB2) zu bestimmen, wenn die Bedingung nicht erfüllt ist.

8. Elektronische Vorrichtung nach Anspruch 4,
wobei der Prozessor (240) dazu konfiguriert ist:
den Ausgangsstrom (ICHGO) des Ladegeräts (210) als einen Konstantstrom zu regeln, bis die Referenzspannung (VSNS) des Ladegeräts (210) einen Zielspannungswert (VCVT) des Ladegeräts (210) erreicht, und
den Ausgangsstrom (ICHGO) des Ladegeräts (210) als eine Konstantspannung derart zu regeln, dass die Referenzspannung (VSNS) auf dem Zielspannungswert (VCVT) des Ladegeräts (210) gehalten wird, wenn die Referenzspannung (VSNS) den Zielspannungswert (VCVT) des Ladegeräts (210) erreicht, und
wobei der Zielspannungswert (VCVT) des Ladegeräts (210) eine vollständig geladene Spannung (VFLOAT) der ersten Batteriezelle (221) oder der zweiten Batteriezelle (231) ist.

9. Verfahren zum Laden einer Batterie einer elektronischen Vorrichtung, die ein Ladegerät (210), einen über einen ersten Pfad elektrisch mit dem Ladegerät (210) verbundenen ersten Batteriepack (220) und einen über einen zweiten Pfad elektrisch mit dem Ladegerät (210) verbundenen zweiten Batteriepack (230) umfasst, wobei der zweite Pfad eine höhere Impedanz als der erste Pfad aufweist, wobei der erste Batteriepack (220) eine erste Batteriezelle (221), einen ersten Lastschalter (222) und eine erste Stromerfassungsschaltung (225) umfasst, die einen durch den ersten Lastschalter (222) fließenden ersten Batteriezellenstrom (IB1) erfasst, wobei das Verfahren umfasst:
Aktivieren, durch einen Prozessor (240) der elektronischen Vorrichtung, einer Konstantstromfunktion des im ersten Batteriepack (220) enthaltenen ersten Lastschalters (222), wenn der erste Batteriezellenstrom (IB1) gleich oder größer als ein maximal zulässiger Strom (ICC1) der ersten Batteriezelle (221) ist; und
Ermöglichen, durch den Prozessor (240), dass das Ladegerät (210) einen Ausgangsstrom (ICHGO) des Ladegeräts (210) verringert, bis die Konstantstromfunktion des ersten Lastschalters (222) deaktiviert wird, wenn der erste Batteriezellenstrom (IB1) kleiner als der maximal zulässige Strom (ICC1) der ersten Batteriezelle (221) ist.

10. Verfahren nach Anspruch 9,
wobei der erste Batteriepack (220) eine erste Spannungserfassungsschaltung (224) umfasst, die eine an beiden Enden der ersten Batteriezelle (221) anliegende erste Batteriezellenspannung (VB1) erfasst, und
wobei der zweite Batteriepack (230) eine zweite Batteriezelle (231), einen zweiten Lastschalter (232), eine zweite Spannungserfassungsschaltung (234), die eine an beiden Enden der zweiten Batteriezelle (231) anliegende zweite Batteriezellenspannung (VB2) erfasst, und eine zweite Stromerfassungsschaltung (235) umfasst, die einen durch den zweiten Lastschalter (232) fließenden zweiten Batteriezellenstrom (IB2) erfasst.

11. Verfahren nach Anspruch 10, wobei der erste Lastschalter (222) ermöglicht, dass der erste Batteriezellenstrom (IB1) kleiner als ein maximal zulässiger Strom (ICC1) der ersten Batteriezelle (221) ist, wenn die Konstantstromfunktion des ersten Lastschalters (222) des ersten Batteriepacks (220) aktiviert ist.

## Revendications

1. Dispositif électronique comprenant :
un chargeur (210) ;
un premier bloc-batterie (220) connecté électriquement au chargeur (210) par l'intermédiaire d'un premier trajet ;
un second bloc-batterie (230) connecté électriquement au chargeur (210) par l'intermédiaire d'un second trajet ayant une impédance plus élevée que le premier trajet ;
dans lequel le premier bloc-batterie (220) comprend une première cellule de batterie (221), un premier interrupteur de charge (222) et un premier circuit de détection de courant (225) qui détecte un premier courant de cellule de batterie (IB1) circulant à travers le premier interrupteur de charge (222) ; et
un processeur (240) connecté électriquement au chargeur (210), au premier bloc-batterie (220) et au second bloc-batterie (230),
**caractérisé en ce que**,
le processeur (240) est configuré pour :
activer une fonction de courant constant du premier interrupteur de charge (222) compris dans le premier bloc-batterie (220) lorsque le premier courant de cellule de batterie (IB1) est égal ou supérieur à un courant maximal admissible (ICC1) de la première cellule de batterie (221),
permettre au chargeur (210) de diminuer un courant de sortie (ICHGO) du chargeur (210) jusqu'à ce que la fonction de courant constant du premier interrupteur de charge (222) soit désactivée lorsque le premier courant de cellule de batterie (IB1) est inférieur au courant maximal admissible (ICC1) de la première cellule de batterie (221).

2. Dispositif électronique selon la revendication 1,
dans lequel le premier bloc-batterie (220) comprend un premier circuit de détection de tension (224) qui détecte une première tension de cellule de batterie (VB1) appliquée aux deux extrémités de la première cellule de batterie (221), et
dans lequel le second bloc-batterie (230) comprend une seconde cellule de batterie (231), un second interrupteur de charge (232), un second circuit de détection de tension (234) qui détecte une seconde tension de cellule de batterie (VB2) appliquée aux deux extrémités de la seconde cellule de batterie (231), et un second circuit de détection de courant (235) qui détecte un second courant de cellule de batterie (IB2) circulant à travers le second interrupteur de charge (232).

3. Dispositif électronique selon la revendication 2, dans lequel le premier interrupteur de charge (222) permet au premier courant de cellule de batterie (IB1) d'être inférieur à un courant maximal admissible (ICC1) de la première cellule de batterie (221) lorsque la fonction de courant constant du premier interrupteur de charge (222) du premier bloc-batterie (220) est activée.

4. Dispositif électronique selon la revendication 2, dans lequel le processeur (240) est configuré pour permettre qu'une tension de référence (VSNS) du chargeur (210) soit modifiée de la première tension de cellule de batterie (VB1) à la seconde tension de cellule de batterie (VB2) en réponse à la satisfaction d'une condition.

5. Dispositif électronique selon la revendication 4, dans lequel la condition consiste à déterminer si une différence entre la première tension de cellule de batterie (VB1) et la seconde tension de cellule de batterie (VB2) est égale ou supérieure à une valeur de tension seuil (Vth).

6. Dispositif électronique selon la revendication 4, dans lequel le processeur (240) est configuré pour :
régler une valeur de tension cible (VCVT) du premier interrupteur de charge (222) à une tension de charge complète (VFLOAT) de la première cellule de batterie (221) ; et
activer une fonction de tension constante du premier interrupteur de charge (222) lorsque la condition est satisfaite.

7. Dispositif électronique selon la revendication 4, dans lequel le processeur (240) est configuré pour déterminer la tension de référence (VSNS) du chargeur (210) comme étant la plus grande valeur parmi la première tension de cellule de batterie (VB1) et la seconde tension de cellule de batterie (VB2), lorsque la condition n'est pas satisfaite.

8. Dispositif électronique selon la revendication 4,
dans lequel le processeur (240) est configuré pour :
commander le courant de sortie (ICHGO) du chargeur (210) comme un courant constant jusqu'à ce que la tension de référence (VSNS) du chargeur (210) atteigne une valeur de tension cible (VCVT) du chargeur (210), et
commander le courant de sortie (ICHGO) du chargeur (210) comme une tension constante de telle sorte que la tension de référence (VSNS) soit maintenue à la valeur de tension cible (VCVT) du chargeur (210) lorsque la tension de référence (VSNS) atteint la valeur de tension cible (VCVT) du chargeur (210), et
dans lequel la valeur de tension cible (VCVT) du chargeur (210) est une tension de charge complète (VFLOAT) de la première cellule de batterie (221) ou de la seconde cellule de batterie (231).

9. Procédé de charge d'une batterie d'un dispositif électronique comprenant un chargeur (210), un premier bloc-batterie (220) connecté électriquement au chargeur (210) par l'intermédiaire d'un premier trajet, et un second bloc-batterie (230) connecté électriquement au chargeur (210) par l'intermédiaire d'un second trajet ayant une impédance plus élevée que le premier trajet, dans lequel le premier bloc-batterie (220) comprend une première cellule de batterie (221), un premier interrupteur de charge (222) et un premier circuit de détection de courant (225) qui détecte un premier courant de cellule de batterie (IB1) circulant à travers le premier interrupteur de charge (222), le procédé comprenant :
l'activation, par un processeur (240) du dispositif électronique, d'une fonction de courant constant du premier interrupteur de charge (222) compris dans le premier bloc-batterie (220) lorsque le premier courant de cellule de batterie (IB1) est égal ou supérieur à un courant maximal admissible (ICC1) de la première cellule de batterie (221) ; et
le fait de permettre, par le processeur (240), au chargeur (210) de diminuer un courant de sortie (ICHGO) du chargeur (210) jusqu'à ce que la fonction de courant constant du premier interrupteur de charge (222) soit désactivée lorsque le premier courant de cellule de batterie (IB1) est inférieur au courant maximal admissible (ICC1) de la première cellule de batterie (221).

10. Procédé selon la revendication 9,
dans lequel le premier bloc-batterie (220) comprend un premier circuit de détection de tension (224) qui détecte une première tension de cellule de batterie (VB1) appliquée aux deux extrémités de la première cellule de batterie (221), et
dans lequel le second bloc-batterie (230) comprend une seconde cellule de batterie (231), un second interrupteur de charge (232), un second circuit de détection de tension (234) qui détecte une seconde tension de cellule de batterie (VB2) appliquée aux deux extrémités de la seconde cellule de batterie (231), et un second circuit de détection de courant (235) qui détecte un second courant de cellule de batterie (IB2) circulant à travers le second interrupteur de charge (232).

11. Procédé selon la revendication 10, dans lequel le premier interrupteur de charge (222) permet au premier courant de cellule de batterie (IB1) d'être inférieur à un courant maximal admissible (ICC1) de la première cellule de batterie (221) lorsque la fonction de courant constant du premier interrupteur de charge (222) du premier bloc-batterie (220) est activée.
